# EUROPEAN PATENT APPLICATION

(11) **EP 1 950 810 A2**
(43) Date of publication of application: **30.07.2008**
(21) Application number: 08100752.8
(22) Date of filing: 22.01.2008
(51) Int. Cl.: H01L 31/0352

(54) **Method and apparatus for a semi conductor structure forming at least one via**

(30) Priority: 23.01.2007 US 626036
(71) Applicant: General Electric Company, Schenectady, NY 12345 (US)
(72) Inventor: Korevaar, Bastiaan Arie, Schenectady, NY 12305 (US); Johnson, James Neil, Scotia, NY 12302 (US)
(74) Representative: Illingworth-Law, William Illingworth

(57) **Abstract**

One exemplary embodiment of a semiconductor structure (100) can include:
(a) a semiconductor substrate (120) of one conductivity type, having a front surface (124) and a back surface (132) and including at least one via (110) through the semiconductor substrate (120), where the at least one via (110) is filled with a conductive material (118); and
(b) a semiconductor layer (200) disposed on at least a portion (136) of the front or back surface (124 or 132) of the semiconductor substrate (120), where the semiconductor layer (200) is compositionally graded through its depth with one or more selected dopants, and the conductive material (118) is configured to electrically couple the semiconductor layer (200) to at least one front contact (272) disposed on or over the surface (132) of the substrate (120).

## Description

### FIELD

The embodiments described herein generally relate to one or more solar modules. More specifically, the embodiments relate to one or more solar modules based on at least one semiconductor structure forming at least one via.

### BACKGROUND

Devices that rely on the presence of a heterojunction are generally well-known in the art. As used herein, a "heterojunction" is usually formed by contact between a layer or region of one conductivity type (e.g., p-type) with a layer or region of an opposite conductivity type (e.g., n-type), thereby forming a "p-n" junction. Examples of these devices can include thin film transistors, bipolar transistors, and photovoltaic devices (i.e., solar cells).

Generally, photovoltaic devices convert radiation, such as solar, incandescent, or fluorescent radiation, into electrical energy. Sunlight is the typical source of radiation for most devices. The conversion to electrical energy may be achieved by the well-known "photovoltaic effect." According to this phenomenon, radiation striking a photovoltaic device can enter the absorber region of the device, generating pairs of electrons and holes, which are sometimes collectively referred to as photo-generated charge carriers. Generally, the electrons and holes diffuse in the absorber region, and are collected at the contacts.

The increasing interest in solar cells as a reliable form of clean, renewable energy has prompted great efforts in increasing the performance of the cells. Typically, one way to improve cell performance is to improve the photoelectric conversion efficiency of the device. Conversion efficiency is usually measured as the amount of electrical current generated by the device, as a proportion of the light energy that falls on its active surface area. Typical photovoltaic devices only exhibit a conversion efficiency on a module level of about 15% or less. Small increases in photoelectric conversion efficiency, e.g., 1% or less, can represent very significant advances in photovoltaic technology.

In order to improve photovoltaic conversion efficiency, various conditions that contribute to the reduction in cell efficiency can be minimized. Two such deleterious effects that have been attributed to the reduction in overall cell efficiency can include charge carrier recombination and shadowing losses. Thus, improvements in one or both of these areas will generally improve the photovoltaic conversion efficiency, as described further below.

The performance of photovoltaic devices may depend in large part on the composition and microstructure of each semiconductor layer. For example, defects that result from structural imperfections or impurity atoms may reside on the surface or within the bulk of mono-crystalline semiconductor layers and may contribute to charge carrier recombination. Moreover, poly-crystalline semiconductor materials contain randomly-oriented grains, with grain boundaries that induce a large number of bulk and surface defects.

The presence of various defects of this type can be the source of deleterious effects in the photovoltaic device. For example, many of the charge carriers recombine at the defect sites near the heterojunction, instead of continuing on their intended pathway to the collection electrodes. Thus, they may become lost as current carriers. Recombination of the charge carriers can be one of the primary contributors to decreased photoelectric conversion efficiency.

The negative effects of surface defects can be minimized to some degree by passivation techniques. For example, a layer of intrinsic (i.e., undoped) amorphous semiconductor material can be formed on the surface of the substrate. Generally, the presence of this intrinsic layer decreases the recombination of charge carriers at the substrate surface, and thereby improves the performance of the photovoltaic device.

While the introduction of an intrinsic layer may address the recombination problem to some degree, there are some considerable drawbacks remaining. For example, the presence of the intrinsic layer, while beneficial in some ways, may result in the formation of yet another interface, i.e., between the intrinsic layer and the overlying amorphous layer. This new interface can yet be another site for impurities and spurious contaminants to become trapped and to accumulate, and possibly cause additional recombination of the charge carriers. For example, interruptions between the deposition steps during fabrication of a multilayer structure can provide unwelcome opportunities for the entry of the contaminants. Moreover, abrupt band bending at the interface, due to a change in band gap, can lead to a high density of interface states, which is another possible source of recombination.

In addition to the design considerations associated with the issue of charge carrier recombination, shadowing effects, which can also limit the device performance, should be considered. Shadowing effects generally refer to the shadowing created by the presence of the relatively large bus bars on the front surface of the photovoltaic device. The bus bars generally serve as one of the conducting electrodes of the device. Disadvantageously, by placing bus bars on the front surface of the device, a significant proportion of incident light rays can be blocked at the contact areas. The light blockage is generally referred to as "shading" or "shadowing." Shadowing prevents the areas of the underlying active materials from receiving incident radiation, thereby reducing the generation of charge carriers. Obviously, a reduction in charge carriers can reduce the efficiency of the photovoltaic device.

Moreover, having contacts on the front side of the device can increase the complexity of manufacturing modules. Generally, a module can include many devices. Devices with contacts on the front side also generally have contacts on the back side. Contacts on both sides of the device can increase the complexity of manufacturing a module, and hence its cost.

With some of these concerns in mind, improved photovoltaic devices would be welcome in the art. The devices should minimize the problem of charge-carrier recombination at various interface regions between semiconductor layers, as well as the problems associated with, e.g., the shadowing, created by relatively large front contacts. Moreover, the devices should exhibit electrical properties that ensure good photovoltaic performance, e.g., photoelectric conversion efficiency.

### SUMMARY

One exemplary embodiment of a semiconductor structure, can include:
(a) a semiconductor substrate of one conductivity type, having a front surface and a back surface and comprising at least one via through the semiconductor substrate, wherein the at least one via is filled with a conductive material; and
(b) a semiconductor layer disposed on at least a portion of the front or back surface of the semiconductor substrate, wherein the semiconductor layer is compositionally graded through its depth with one or more selected dopants, and the conductive material is configured to electrically couple the semiconductor layer to at least one contact disposed on or over the surface of the substrate.

Another exemplary embodiment of a semiconductor structure, may include:
(a) a semiconductor substrate of one conductivity type, having a front surface and a back surface and forming at least one via through the semiconductor substrate; and
(b) a semiconductor layer disposed on at least a portion of a front or back surface of the semiconductor substrate, wherein the semiconductor layer is compositionally graded through its depth with one or more selected dopants.

A further exemplary embodiment of a semiconductor structure, can include:
(a) a semiconductor substrate of one conductivity type, having a front surface and a back surface and forming at least one via through the semiconductor substrate, wherein the at least one via is filled with a conductive material;
(b) a first layer, which is a semiconductor layer, disposed on the front surface of the semiconductor substrate, wherein the first semiconductor layer, compositionally graded through its depth with one or more selected dopants, comprises: an n-type or p-type nano-crystalline material, an n-type or p-type micro-crystalline material, an n-type or p-type poly-crystalline material, an n⁺ or a p⁺ epitaxial layer, or a combination thereof;
   an n-type or a p-type amorphous layer;
   an intrinsic layer;
   a-Si:H, a-SiC:H, a-SiGe:H, or a combination thereof; or
   µc-Si:H, µc-SiC:H, µc-SiGe:H, or a combination thereof;
(c) a second layer, which is an insulating layer, disposed on an area of the back surface of the semiconductor substrate wherein the second insulating layer comprises an insulating material; and
the conductive material is configured to electrically couple the semiconductor layer to at least one contact disposed on or over the surface of the substrate.

Yet another exemplary embodiment is a method for making a photovoltaic device. The method can include, in any order:
(I) disposing a first semiconductor layer on a front surface of a semiconductor substrate, wherein the first semiconductor layer, optionally compositionally-graded through its depth with one or more selected dopants, comprises a nano-crystalline material, a micro-crystalline material, a poly-crystalline material, an n⁺ epitaxial, or an amorphous layer;
(II) disposing a second semiconductor layer on at least one first area on the back surface of the semiconductor substrate;
(III) disposing a third semiconductor layer on at least one second area on the back surface of the semiconductor substrate, wherein the third semiconductor layer is compositionally graded through its depth, from substantially intrinsic at an interface with the substrate, to substantially conductive at an opposite side;
(IV) forming a plurality of vias through the substrate;
(V) filling each of the plurality of vias with a conductive material;
(VI) forming at least one front contact on the second semiconductor layer; and
(VII) forming at least one back contact on the third semiconductor layer.

A still further embodiment is a semiconductor structure that can include:
(a) a semiconductor substrate of one conductivity type, having a front surface and a back surface and forming at least one via through the semiconductor substrate, wherein the at least one via is filled with a conductive material;
(b) a first layer, which is a semiconductor layer, disposed on the front surface of the semiconductor substrate, wherein the first semiconductor layer, compositionally graded through its depth with one or more selected dopants, comprises:
   an n-type or p-type nano-crystalline material, an n-type or p-type micro-crystalline material, an n-type or p-type poly-crystalline material, an n⁺ or a p⁺ epitaxial layer, or a combination thereof;
   an n-type or a p-type amorphous layer;
   an intrinsic layer;
   a-Si:H, a-SiC:H, a-SiGe:H, or a combination thereof; or
   µc-Si:H, µc-SiC:H, µc-SiGe:H, or a combination thereof;
(c) a second layer, which is a semiconductor layer, disposed on an area of the back surface of the semiconductor substrate wherein the second semiconductor layer comprises a semiconducting material; and the conductive material is configured to electrically couple the semiconductor layer to at least one contact disposed on or over the surface of the substrate.

An additional exemplary embodiment is a semiconductor structure that can include:
(a) a semiconductor substrate of one conductivity type, having a front surface and a back surface and forming at least one via through the semiconductor substrate, wherein the at least one via is filled with a conductive material;
(b) a first layer, which is a semiconductor layer, disposed on the front surface of the semiconductor substrate, wherein the first semiconductor layer, compositionally graded through its depth with one or more selected dopants, comprises:
   an n-type or p-type nano-crystalline material, an n-type or p-type micro-crystalline material, an n-type or p-type poly-crystalline material, an n⁺ or a p⁺ epitaxial layer, or a combination thereof;
   an n-type or a p-type amorphous layer;
   an intrinsic layer;
   a-Si:H, a-SiC:H, a-SiGe:H, or a combination thereof; or
   µc-Si:H, µc-SiC:H, µc-SiGe:H, or a combination thereof;
(c) the semiconductor substrate comprises a doped region diffused into the back surface; and
the conductive material is configured to electrically couple the semiconductor layer to at least one contact disposed on or over the surface of the substrate.

Generally, the embodiments discussed herein can provide passivation techniques to minimize the negative effects of surface defects, and have a smaller absorption coefficient to minimize wasteful light absorption in the structure. Particularly, the absorption coefficient of crystalline silicon is generally much smaller than amorphous silicon. Thus, utilizing a crystalline silicon layer can allow more light to be absorbed in the region where it contributes to the performance of the device. These embodiments can also provide a field effect for minimizing the recombination of charge carriers. Particularly, n⁺ or p⁺ diffused regions in devices can effectively keep minority carriers away from the surface. Incorporating such a field in a semiconductor structure can repel minority carriers. Alternatively, a compositionally graded layer may be incorporated into the structure, without the drawbacks associated with the use of separate, discrete intrinsic and conductive layers. In addition, the present invention can provide anti-reflective properties to improve the performance of the device. One such exemplary property to improve anti-reflectiveness is texturing. Generally, it is preferred that the front of a semiconductor structure is textured. Therefore, it is desirable for a layer of a semiconductor structure to have low absorption, good passivation, and anti-reflection properties. Moreover, having the front and back contacts on the back of the semiconductor structure can reduce cost and increase design flexibility.

### BRIEF DESCRIPTION OF THE DRAWINGS

Advantages and features of the invention may become apparent upon reading the following detailed description of embodiments provided by way of example only and upon reference to the drawings in which:

FIG. 1 is a schematic diagram depicting a module including a plurality of semiconductor structures according to one exemplary embodiment.

FIG. 2 is a schematic cross-section depicting a semiconductor structure according to one exemplary embodiment.

FIG. 3 is a schematic cross-section depicting a semiconductor structure according to another exemplary embodiment.

FIG. 4 is a schematic cross-section depicting a semiconductor structure according to yet another exemplary embodiment.

FIG. 5 is a schematic cross-section depicting a semiconductor structure according to still another exemplary embodiment.

FIG. 6 is a front, plan view of a front surface of a semiconductor structure as depicted in FIG. 2.

### DETAILED DESCRIPTION

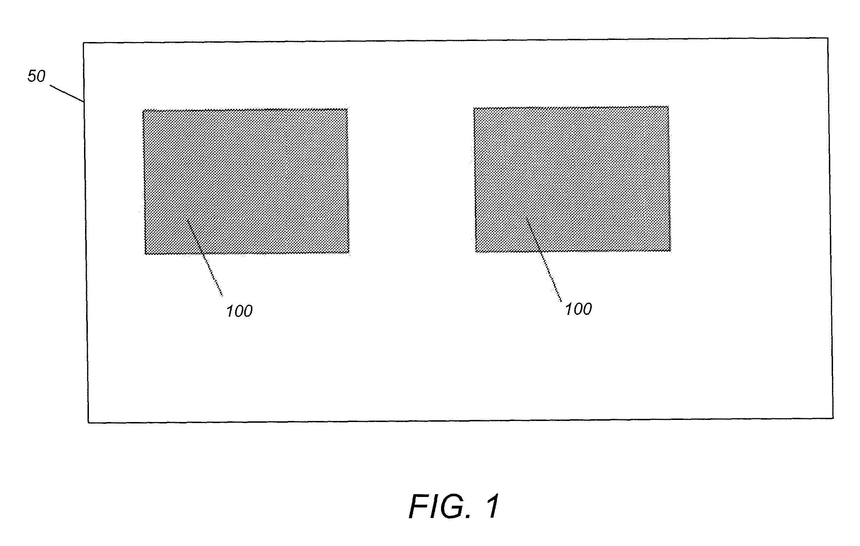

As depicted in FIG. 1, one exemplary embodiment of a solar cell module 50 can include a plurality of semiconductor structures or photovoltaic devices 100. Although a structure 100 is depicted, other structures, e.g. as described herein, can be, independently, utilized.

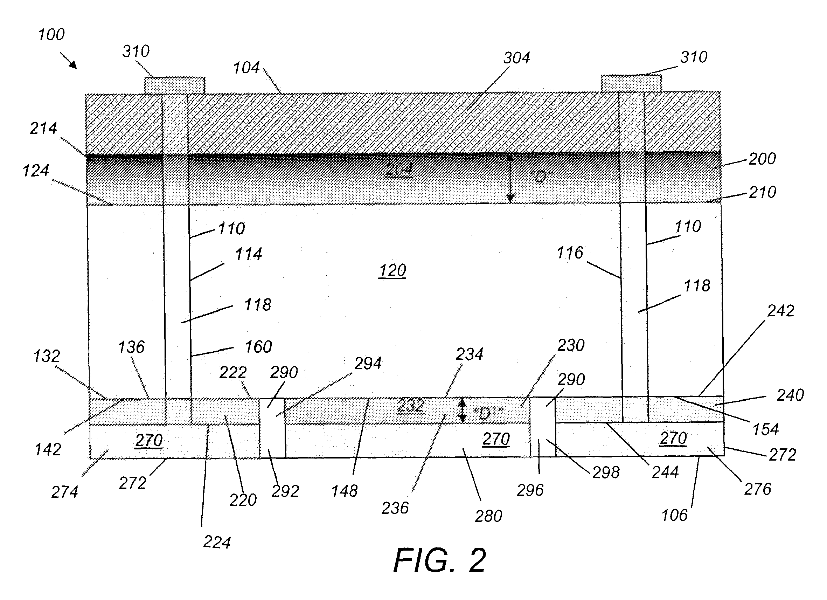

As depicted in FIG. 2, an exemplary semiconductor structure 100 can include a semiconductor substrate 120, a first semiconductor layer 200, a second semiconductor layer 220, a third semiconductor layer 230, a fourth semiconductor 240, at least one electrical contact 270, a transparent conductive layer 304, and a plurality of metal patterns 310. Generally, the semiconductor structure 100 can include a front side 104 and a back side 106, and can include or form at least one via or a plurality of vias 110. Typically, the plurality of vias 110 extend through the layers 304 and 200, the substrate 120, and respectively, the layers 220 and 240. Desirably, the semiconductor structure 100 forms a first via 114 and a second via 116. In one exemplary embodiment, the plurality of vias 110 is filled with a conductive material 118, such as aluminum (Al), silver (Ag), or copper (Cu).

The semiconductor substrate 120 can include a front surface 124 and a back surface 132. In addition, the back surface 132 can be defined by at least a portion 136, which can include an area or a first area 142, another area or a second area 148, and yet another area or a third area 154. Generally, an interface 160 between the substrate 120 and the via 114 is passivated to minimize charge carrier recombination, along with other similar interfaces between the at least one via 110 and the semiconductor substrate 120. The substrate 120 usually has a thickness of about 50 microns - about 600 microns. The substrate 120 can be a crystalline silicon, such as a mono-crystalline material or a multi-crystalline material, including one or more dopants, such as a p-type or an n-type depending, in part, on the electrical requirements for the solar cell module 50. Generally, a mono-crystalline substrate includes a large, single crystal that may include more than one crystal, as long as each crystal is sufficiently sized so electrons and holes do not experience any grain boundaries within the layer. A multi-crystalline material has large grains, but the width of each grain is typically smaller than the thickness of the substrate 120. Those skilled in the art are familiar with the details regarding all of these types of silicon substrates. Desirably, the substrate 120 is an n-type crystalline silicon. In the exemplary embodiment depicted in FIG. 2, semiconductor substrate is an n-type crystalline material. The front and back surfaces of the semiconductor substrate may optionally be textured to enhance light trapping, as discussed further below.

Generally, a first semiconductor layer 200 is formed on the front surface 124 of the substrate 120. The thickness of the first semiconductor layer 200 can be influenced by the extent to which the recombination of charge carriers at the front surface 124 of the substrate 120 is to be minimized. Usually, the thickness of the layer 200 is less than or equal to about 250 angstroms. In some specific cases, the layer 200 can have a thickness in the range of about 50 angstroms - about 300 angstroms. The most appropriate thickness in a given situation can be determined without undue effort, e.g., by taking measurements related to the photoelectric conversion efficiency of the solar cell module 50, which incorporates the semiconductor structure 100, or by determining the optimum thickness of the structure itself.

Usually, the first semiconductor layer 200 is formed on the front of the semiconductor structure 100 on the semiconductor substrate 120, and can be an amorphous or crystalline material. The crystalline material may include an epitaxial layer or film, a poly-crystalline material, a micro-crystalline material or a nano-crystalline material. Moreover, the first semiconductor layer 200, whether amorphous or crystalline material, can be doped or intrinsic.

Generally, an epitaxial layer or film continues the crystal-orientation of and has a similar crystal distribution as the substrate 120, generally making it virtually indistinguishable from the substrate 120 apart from doping. A poly-crystalline layer is generally a film that may contain large crystals, but in a more random orientation that is not necessarily dependent on the crystal orientation of the substrate 120. A micro-crystalline layer or film is generally a mixed crystalline-amorphous film that can contain crystal grains in the micron range (about 0.5 - about 5 microns). Because these micro-crystalline films are relatively thin, the crystal grains typically are visible in two-dimensions with an amorphous phase in the space between the crystals. A nano-crystalline layer or film is similar to a micro-crystalline film, but typically with much smaller dimensions for the crystals. Typical ordered areas have dimensions between about 1 and about 10 nanometers embedded in a mainly amorphous matrix. An amorphous material is usually a film that has no order in the structure. Any of these crystal layers can be doped with an n-type or a p-type dopant, or can be intrinsic.

In this exemplary embodiment, the substrate 120 is doped with one or more n-type dopants. The first semiconductor layer 200 can be a crystalline silicon, or specifically, a nano-crystalline silicon (nc-Si:H), a micro-crystalline silicon (µc-Si:H), a micro-crystalline silicon carbide (µc-SiC:H), a micro-crystalline silicon germanium (µc-SiGe:H), or a combination thereof. Alternatively, the first semiconductor layer can be an amorphous silicon, or specifically a hydrogenated amorphous silicon (a-Si:H), amorphous silicon carbide (a-SiC:H), amorphous silicon germanium (a-SiGe:H), or a combination thereof. Preferably, the layer 200 is an a-Si:H or nc-Si:H. Moreover, the first semiconductor layer 200 can include a plurality of layers or sub-layers as described hereinafter. If the semiconductor layer 200 includes a plurality of layers, generally all the layers are either amorphous or crystalline material. If the plurality of layers is a crystalline material, each layer can be the same or different type of crystalline material. Also, the first semiconductor layer 200 can be "compositionally graded", or can include doping at the interface, as discussed hereinafter.

As depicted in FIG. 2, a semiconductor layer 200 that is compositionally graded 204 can include dopants to a depth "D". Particularly, the semiconductor layer 200 can have no or few dopants at an interface 210 with the substrate 120, and can have increasing amount of dopants at an opposite region 214. The term "compositionally-graded" is meant to describe a change (i.e., a "gradation") in dopant concentration as a function of the depth "D" of the layer 200. In some embodiments, the gradation is substantially continuous, but this does not always have to be the case. As an example, the rate-of-change in concentration may itself vary through the depth, increasing slightly in some regions, and decreasing slightly in others. However, the overall gradation is always characterized as a decrease in dopant concentration in the direction towards the substrate 120. Moreover, in some instances, the dopant concentration may remain constant for some portion of the depth, although that portion would probably be very small. Any and all of these variations and gradations are meant to be encompassed by the term "graded". A specific dopant concentration profile for a given semiconductor layer will depend on various factors, e.g., the type of dopant and the electrical requirements for the semiconductor device, as well as its microstructure and thickness. Generally, the dopant concentration is substantially zero at the interface 210 with the substrate, regardless of the particular dopant profile. Thus, an intrinsic region is present at the interface 210, functioning to minimize recombination of the charge-carriers. At the opposite upper surface of the amorphous layer 200, at opposite region 214 is substantially conductive. The specific dopant concentration in that region will depend on the particular requirements for the semiconductor device. As a non-limiting example in the case of a poly-crystalline or single crystalline silicon substrate 120, the opposite side can have a concentration of dopant in the range of about 1 x 10¹⁶ cm⁻³ - about 1 x 10²¹ cm⁻³. The concept of compositional grading for these types of layers is also generally described in U.S. Patent Application Number 11/263,159, filed on October 31, 2005, for J. Johnson and V. Manivannan. A benefit of compositional grading is to provide a field effect at an interface between, e.g., the substrate 120 and the layer 200, without the drawbacks associated with the use of separate, discrete intrinsic and conductive layers. As depicted in FIG. 2, the first semiconductor layer 200 is an amorphous silicon layer, that is compositionally-graded with p-type dopants.

The thickness of the graded layer 200 may also depend on various factors, such as the type of dopant employed, the conductivity-type of the substrate, the grading profile, the dopant concentration at the opposite side 124, and the optical band gap of layer 200. Usually, the thickness of layer 200 is less than or equal to about 250 angstroms. In some specific embodiments, the graded layer 200 has a thickness in the range of about 30 angstroms - about 180 angstroms. The most appropriate thickness in a given situation can be determined without undue effort, e.g., by taking measurements related to the photoelectric conversion efficiency of the device, as well as its open circuit voltage (Voc) and short circuit current (Isc).

The second semiconductor layer 220 can be formed on at least a portion 136, desirably an area or a first area 142, of the back surface 132 of the substrate 120. The second semiconductor layer 220 can form an interface 222 with the substrate 120 and have an opposite side 224.

The fourth semiconductor layer 240 can be formed on at least the portion 136, desirably yet another area or third area 154, of the back surface 132 of the semiconductor substrate 120. The first area 142 and the third area 154 can be the same or different size, preferably the same size. Similarly, the fourth semiconductor layer 240 can form an interface 242 with the semiconductor substrate 120 and have an opposite side 244. The second semiconductor layer 220 and fourth semiconductor layer 240 can be an amorphous or crystalline silicon layer. The second semiconductor layer 220 and the fourth semiconductor layer 240 can be, independently, a type of crystalline layer as described above for the first semiconductor layer 200. Moreover, these layers 220 and 240 can be, independently, doped or intrinsic. As an example, the second semiconductor layer 220 and the fourth semiconductor layer 240 can be graded. In those instances where the substrate 120 is an n-type substrate, layers 220 and 240 can alternatively contain a diffused layer if a field effect is desired to repel electrons from that region. Thus, the layers 220 and 240 can be optionally doped with graded or diffused layers. Exemplary materials for the second semiconductor layer 220 and the fourth semiconductor layer 240 can include a graded (i-p) a-Si-H, an intrinsic a-Si:H, or a p-type a-Si:H, or preferred layers discussed above for the first semiconductor layer 200. Alternatively, in another embodiment the second semiconductor layer 220 and the fourth semiconductor layer 240 are replaced with respective layers including an insulating material, such as SiO₂, and thus are insulating layers. In preferred embodiments, these insulating layers have passivating characteristics. As described below, the front and back surfaces 124 and 132 of the semiconductor substrate 120 may optionally be textured to enhance light trapping.

The third semiconductor layer 230 can be formed on the portion 136, desirably another area or second area 148, of the back surface 132 of the semiconductor substrate 120. Generally, the second area 148 can be much larger than the first area 142 and the third area 154. Desirably, the third semiconductor layer 230 is compositionally graded 232 to a depth "D¹". The third semiconductor layer 230 can form an interface 234 with the substrate 120 and have an opposite region 236. Typically, the concentration of dopants at the interface 234 is minimized or non-existent and increases at the opposite region 236. In this exemplary embodiment, the compositionally graded layer 230 is an amorphous layer graded with n-type dopants. The graded amorphous layer 230 can include a substantially intrinsic portion at an interface 234, and a substantially conductive portion with one or more n-type dopants at an opposite region 236. The layer 230 may include an intrinsic-to-n-type compositional grading.

As discussed above, the substrate 120 is usually an n-type substrate. However, it should be understood that if the substrate 120 is a p-type substrate, then the various layers described herein will be the opposite type, i.e., a p-type layer would be an n-type layer and an n-type layer would be a p-type layer. As an example, if the substrate 120 is a p-type substrate 120, then the first semiconductor layer 200 and optionally the second and fourth semiconductor layers 220 and 240 would be n-type, and the third semiconductor layer 230 would be a p-type. Similarly, diffused regions would also be reversed if the substrate 120 is a p-type substrate.

Although not depicted, an electrode layer can be positioned on each of the second semiconductor layer 220, the third semiconductor layer 230, and the fourth semiconductor layer 240. However, such an electrode layer is optional. Desirably, an electrode layer, if present, is formed from a transparent conductive oxide, such as indium tin oxide.

Generally, the structure 100 includes at least one electrical contact 270, preferably a plurality of front contacts 272 and at least one back contact 280. The plurality of front contacts 272 can include a first front contact 274 and a second front contact 276. Each contact 274 and 276 can be formed over, respectively, the second semiconductor layer 220 and the fourth semiconductor layer 240, or over an electrode layer, if present. At least one electrical contact 270 can function as a conducting electrode, conveying the electric current generated by the module 50 to a desired location. The at least one contact 270 may be formed of a variety of conductive materials, such as silver (Ag), aluminum (Al), copper (Cu), molybdenum (Mo), tungsten (W), titanium (Ti), palladium (Pd) or a combination thereof. Although each of the first and second contacts 274 and 276 are illustrated as a layer of material in FIG. 2, their respective shape and size can vary considerably. Each electrical contact 274 and 276 can be formed by various techniques, e.g., plasma deposition, screen-printing, vacuum evaporation (sometimes using a mask), sputtering, pneumatic dispensing, or direct techniques such as inkjet printing.

In addition, at least one back contact 280 can be formed over the third semiconductor layer 230. Optionally, the at least one back contact 280 can be interdigitated with the plurality of front contacts 272. Desirably, at least one isolation trench 290 is formed between the semiconductor layers 220, 230, and 240. The at least one contact 270 can also be isolated from the contact 280. In this preferred embodiment, a first isolation trench 292 is formed by the third semiconductor layer 230 being spaced apart from the second semiconductor layer 220, and the fourth semiconductor layer 240 being spaced apart from the third semiconductor layer 230. So, a first isolation trench 292 and a second isolation trench 296 are formed between the layers 220, 230 and 240, as well as their respective overlying contacts 274, 280 and 276. Desirably, each isolation trench 292 and 296 is filled with, respectively, a first electrically-insulating material 294 and a second electrically-insulating material 298, such as silicon dioxide. Thus, the plurality of front contacts 272 can be electrically isolated from the back contact 280.

Further, the semiconductor structure 100 can also include a transparent or anti-reflective layer 304. According to this exemplary embodiment, the layer 304 is disposed on the first semiconductor layer 200 on the front or light-receiving side 104 of the structure 100. The layer 304 can provide anti-reflective (AR) characteristics for the semiconductor structure 100, and may include a variety of materials, such as metal oxides. Non-limiting examples include silicon dioxide (SiO₂), silicon nitride (SiN), zinc oxide (ZnO), doped ZnO, and indium tin oxide (ITO). The layer 304 can be formed by various conventional techniques, such as sputtering or evaporation. Its thickness will depend on various factors, including desired AR characteristics. Usually, the layer 304 can have a thickness in the range of about 200 angstroms - about 2,000 angstroms.

Generally, the metal patterns 310 are disposed on the front conductive layer 304 and the contacts 274 and 276 are disposed on the back side of the photovoltaic device 100. The electrical interconnection between the plurality of metal patterns 310 and the contacts 274 and 276 is accomplished by a highly conductive material 118, such as aluminum, at least partially filling the vias 114 and 116 formed through the substrate 120. The vias 114 and 116 may be formed by any one of a number of techniques, including etching (e.g., wet chemical etching or plasma etching), mechanical abrasion, drilling using lasers or ultrasonic techniques. Laser ablation is a fast process meeting the overall targets of solar cell processing and may be preferential in many applications. For instance, a Q-switched Nd:YAG laser beam may be used to form the vias 114 and 116. The vias 114 and 116 may be formed from the back side 106 of the structure 100, through the layer 220, the substrate 120, the layer 200, and the layer 304 to expose the front surface of the photovoltaic device 100. Once the vias 114 and 116 are formed, the electrical interconnection may be accomplished by disposing a highly conductive material 118, such as copper (Cu), to partially or fully fill the vias 114 and 116. Desirably, the interface 160 at the, e.g., via 114 and the substrate 120 is passivated to prevent charge carrier recombination.

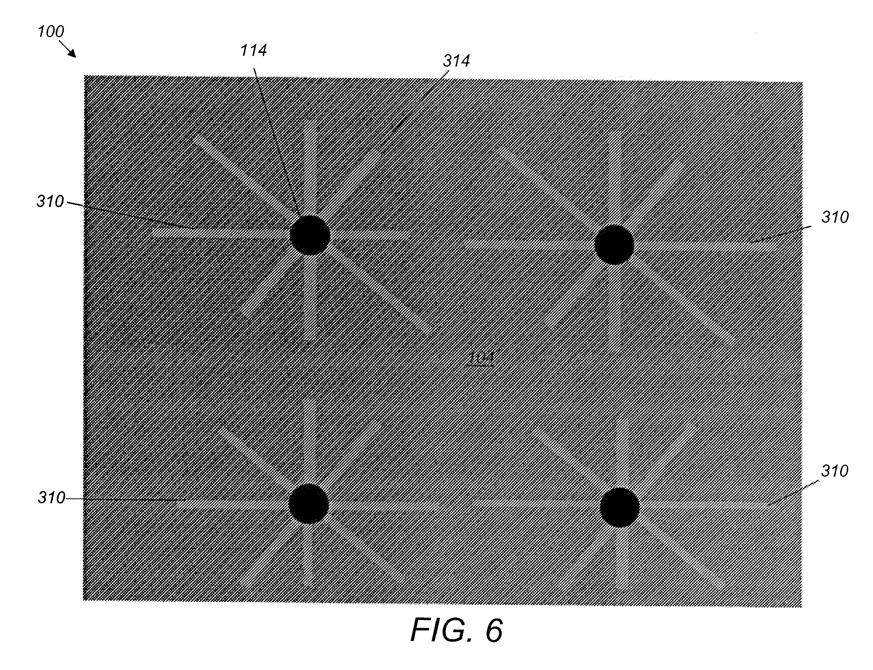

Additionally, a plurality of metal patterns 310 can be formed on the layer 304 around the at least one via 110. The plurality of metal patterns 310 will be described in further detail with reference to FIG. 6.

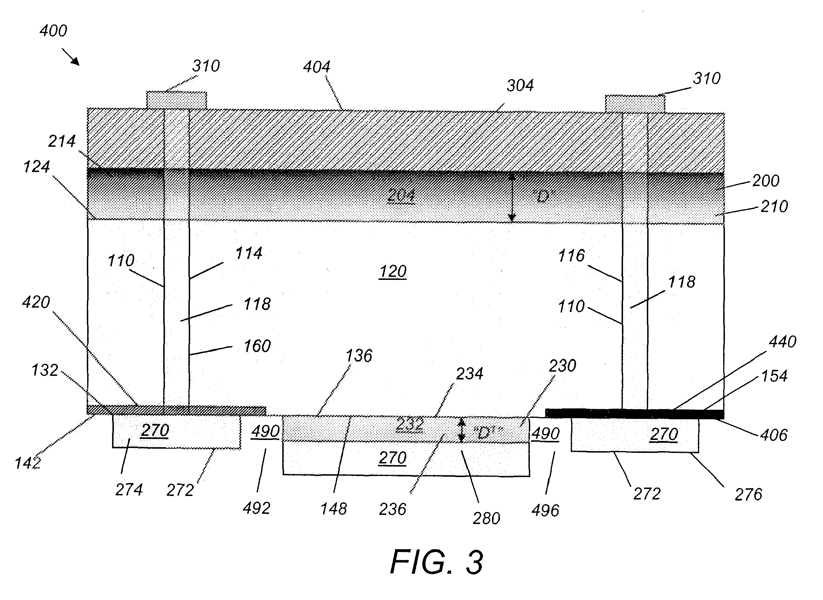

Another exemplary embodiment of a semiconductor structure 400 is depicted in FIG. 3. (In this figure, and hereinafter, many of the elements similar or identical to an earlier figure may not be labeled, or provided with the same element numerals as an earlier figure.) The semiconductor structure 400 includes a substrate 120, a first semiconductor layer 200, a third semiconductor layer 230, at least one electrical contact 270, a transparent conductive layer 304, and a plurality of metal patterns 310. The substrate 120, the first semiconductor layer 200, the third semiconductor layer 230, the at least one electrical contact 270, and the metal patterns 310 are substantially similar as those described above.

The semiconductor structure 400 can include a front side 404 and a back side 406. Referring to the back side 406, the second semiconductor structure 400 can have a first doped region 420 and a second doped region 440 diffused into the back surface 132 instead of the second semiconductor layer 220 and the fourth semiconductor layer 240, as depicted in FIG. 2. Desirably, these regions have a concentration of p-type dopants if the substrate 120 is n-type, namely respective diffused p⁺-regions sufficient to provide a field effect to repel electrons. In addition, at least one isolation trench 490, particularly a first isolation trench 492 and a second isolation trench 496, can be formed between the third semiconductor layer 230 and the at least one electrical contact 270. Optionally, these isolation trenches 492 and 496 can be filled with an electrically insulating material, such as silicon dioxide. In an alternative embodiment, the front contacts 274 and 276 with the respective diffused regions 420 and 440 can sandwich respective electrode layers.

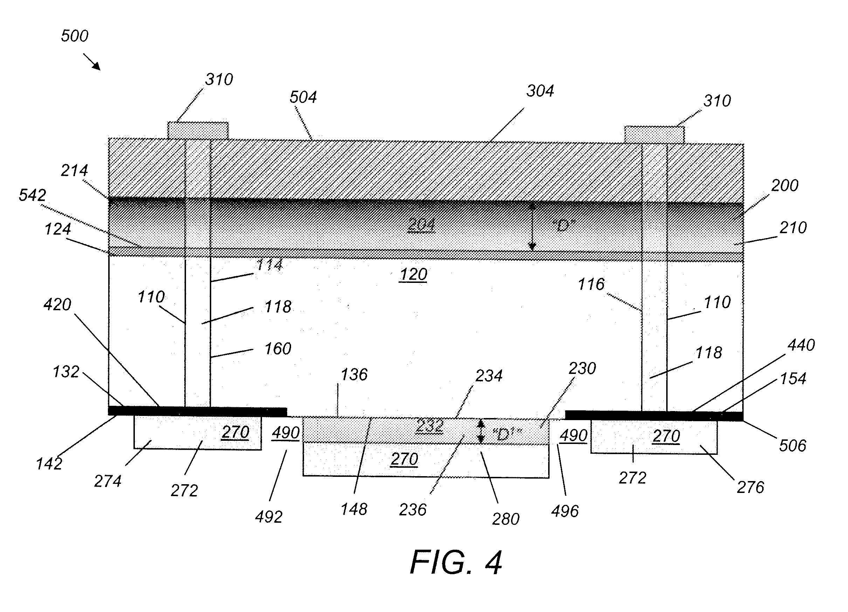

Referring to FIG. 4, an exemplary third semiconductor structure 500 can include a front side 504 and a back side 506. The third semiconductor structure 500 is substantially similar to the semiconductor structure 400, as depicted in FIG. 3, except an interface 542 can be doped with the desired dopants. In this instance, if the semiconductor layer 200 is graded with p-type dopants, then the interface 542 can also include p-type dopants.

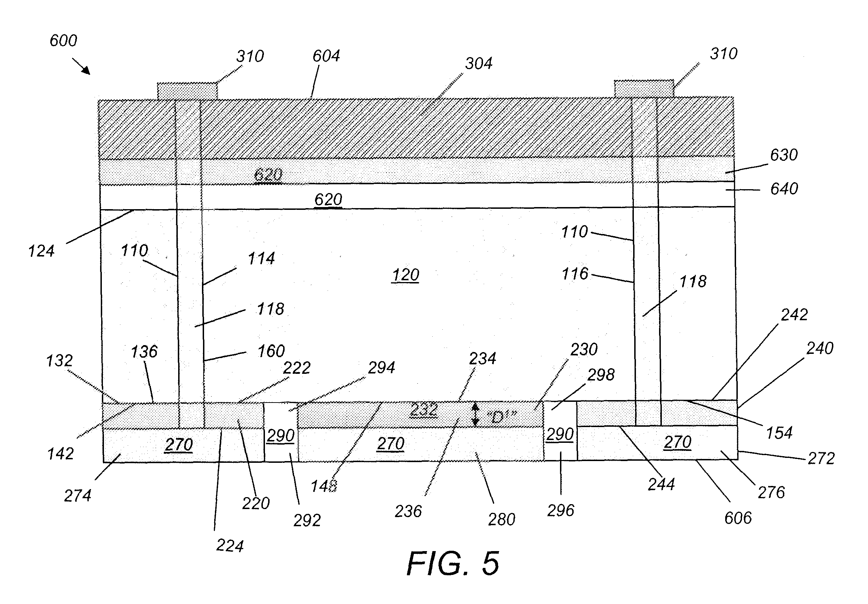

Referring to FIG. 5, a fourth semiconductor structure 600, having a front side 604 and a back side 606, is substantially similar to the semiconductor 100, except a plurality of layers 620 are included. Particularly, the plurality of layers 620 replace the first semiconductor layer 200. The plurality of layers 620 can include a first semiconductor layer or sub-layer 630 and a second semiconductor layer or sub-layer 640. Similarly, as discussed above, these layers 630 and 640 can both be either amorphous or crystalline material. With respect to the particular type of crystalline layer, these layers, independently, can be a crystalline layer as described above. In this particular embodiment, if the substrate is an n-type substrate 120, then the plurality of layers 620 can include a p-type dopant.

Referring to FIG. 6, a plurality of metal patterns 310 is depicted on the front side 104 of a semiconductor structure 100. Typically, each metal pattern 310 can include at least one gridline 314. These metal gridlines can be made of any suitable conductive material, and generally extend from a via 114. As depicted, a simple schematic of a star-like metal grid can be used, but any other shape of gridlines can also be utilized. The via 114 can be filled with a metal that generally extends through the semiconductor structure 100, and contact the metal pattern 310 that is on the front side 104 of the semiconductor structure 100. Such metal patterns 310 can reduce the amount of shadowing as compared to bus-bars that would be typically deposited on the front 104 of the semiconductor 100. So desirably, such a structure 100 can provide a more efficient solar cell module 50.

The substrate 120 is usually subjected to conventional treatment steps, prior to deposition of the other semiconductor layers. For example, the substrate 120 can be cleaned and placed in a vacuum chamber (e.g., a plasma reaction chamber, as described below). The chamber can then be heated to temperatures sufficient to remove any moisture on or within the substrate 120. Usually, a temperature in the range of about 120 - about 240° C is sufficient to remove any moisture. Sometimes, hydrogen gas is then introduced into the chamber, and the substrate 120 is exposed to a plasma discharge for additional surface-cleaning. However, many variations on cleaning and pretreatment steps are possible.

The various semiconductor layers formed over the substrate are usually applied by plasma deposition. Many different types of plasma deposition are possible. Non-limiting examples include chemical vapor deposition (CVD), vacuum plasma spray (VPS), low pressure plasma spray (LPPS), plasma-enhanced chemical-vapor deposition (PECVD), radio-frequency plasma-enhanced chemical-vapor deposition (RFPECVD), expanding thermal-plasma chemical-vapor deposition (ETPCVD), electron-cyclotron-resonance plasma-enhanced chemical-vapor deposition (ECRPECVD), inductively coupled plasma-enhanced chemical-vapor deposition (ICPECVD), and air plasma spray (APS). Sputtering techniques could also be used, e.g., reactive sputtering. Moreover, combinations of any of these techniques might also be employed. Those skilled in the art are familiar with the general operating details for all of these deposition techniques. In some preferred embodiments, the various semiconductor layers are formed by a PECVD process.

The semiconductor structures depicted above can be made by methods known to those of skill in the art. Particularly, the method of making various crystalline layers can be accomplished by chemical vapor deposition (CVD). Such methods are provided in, e.g., U.S. Patent Number 7,075,052 B2 (Shima et al.). Moreover, creating diffused dopant regions in substrates are also known to those who are skilled in the art. Such diffused regions can be created by low pressure chemical vapor deposition (LPCVD) followed by a high temperature diffusion step, as disclosed by, e.g., U.S. Patent Number 6,110,772 (Takada et al.).

The compositional-grading of, e.g., the semiconductor layer 200 can be carried out by various techniques. The deposition of each layer is typically undertaken in separate steps. Usually, grading is accomplished by adjusting the dopant levels during plasma deposition. In a typical embodiment, a silicon precursor gas such as silane (SiH₄) is introduced into the vacuum chamber in which the substrate 120 is situated. A diluting gas such as hydrogen may also be introduced with the silicon precursor gas. Flow rates for the precursor gas can vary considerably, but are typically in the range of about 10 sccm - about 300 sccm for typical test-reactors, but can vary significantly depending on the configuration of the deposition chamber. During the initial stages of deposition, no dopant precursors are present. Therefore, regions near an interface with the substrate 120 are substantially intrinsic ("undoped"), as mentioned above, thus serving to passivate the surface of substrate 120.

As an example, the deposition process continues for the layer 200, as a dopant precursor is added to the plasma mixture. Choice of a precursor will of course depend on the selected dopant. An n-type dopant such as a Group V element, e.g., phosphorus (P), arsenic (As), or antimony (Sb); or a p-type dopant such as a Group III element, e.g., boron (B), may be utilized. A vehicle, such as diborane gas (B₂H₆) for the p-type dopant or phosphine (PH₃) for the n-type dopant, can deliver the selected dopant. The vehicle gases may be in pure form, or they may be diluted with a carrier gas, such as argon, hydrogen, or helium.

The addition of the dopant gas is carefully controlled to provide the desired doping profile. Those skilled in the art are familiar with gas metering equipment, e.g., mass flow controllers, which can be used to carry out this task. The feed rate for the dopant gas will be selected to substantially match the gradation scheme described above. Thus, in very general terms, the feed rate of the dopant gas will gradually increase during the deposition process. However, many specific changes in feed rate can be programmed into the deposition scheme. Referring to FIG. 2, the process results in the formation of a substantially-conductive material at the opposite region 214, as mentioned previously. The material at the opposite region 214 generally has a dopant type opposite that of the substrate 120. Thus, at least a portion of the semiconductor layer 200 forms a heterojunction with the substrate 120. In the present exemplary embodiment, wherein the substrate 120 is an n-type silicon substrate, the graded layer 200 is an intrinsic-to-p-type graded amorphous silicon, for instance. That is, the layer 200 is graded, such that the material at the interface 210 is intrinsic and the material at the opposite region 214 is doped with a p-type dopant.

As discussed above, generally the plurality of front contacts 272 are electrically isolated from the at least one back contact 280. In the exemplary embodiment as depicted in FIG. 2, the isolation trenches 292 and 296 are formed such that each of the front contacts 274 and 276 on the back side 106 are electrically isolated from the at least one back contact 280 on the back side 106. In accordance with one exemplary embodiment, a continuous layer of conductive material (e.g., metal) may be disposed on the back side 106, by a conventional technique. Once the contact metal has been disposed, the trenches 292 and 296 may be formed through the metal layer and the underlying layers 220, 230, and 240 to isolate the front and back contacts 274, 276, and 280.

In each of the embodiments described herein, the front and back contacts may be located on the back side of the device to minimize shading losses associated with contacts being disposed on the front surface, wherein incident light rays may be blocked by contacts located on the front surface. Advantageously, forming the front and back contacts on the back side of the device can provide a more efficient device.

In each of the embodiments described herein, the graded layer eliminates at least one interface between discrete multilayers, i.e., interfaces where charge carrier-recombination can occur, as discussed previously. Grading of the dopant concentration through a single layer is thought to provide a continuous variation of localized states in the energy band gap for the particular device, thereby eliminating abrupt band-bending. Moreover, the graded layer can also result in processing advantages during fabrication of the devices, as mentioned previously. For example, interruptions between deposition steps are minimized, so that there is less of an opportunity for the entry of contaminants.

The semiconductor structure can be incorporated into the form of a solar module. For example, a number of the structures or photovoltaic devices can be, independently, electrically connected to each other, in series or in parallel, to form the solar cell module. (Those of ordinary skill in the art are familiar with details regarding the electrical connections, etc.) Such a module is capable of much greater energy output than the individual structures.

Non-limiting examples of solar modules are described in various references, e.g., U.S. Patent Number 6,667,434 (Morizane et al.). The modules can be formed by various techniques. For example, a number of structures can be sandwiched between glass layers, or between a glass layer and a transparent resin sheet, e.g., those made from EVA (ethylene vinyl acetate). Thus, according to some embodiments of this invention, solar cell modules contain at least one structure, which itself comprises a compositionally-graded layer adjacent a semiconductor substrate, as described previously. The use of the graded layers can improve module properties like photoelectric conversion efficiency, etc., and thereby improve the overall performance of the solar module.

In general, those skilled in the art are familiar with many other details regarding the primary components of the solar modules, e.g., the various substrate materials, backing materials, and module frames. Other details and considerations are also well-known, e.g., wire connections in and out of the module (for example, those leading to an electrical inverter); as well as various module encapsulation techniques.

This written description uses examples to disclose the invention, including the best mode, and also to enable any person skilled in the art to make and use the invention. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A semiconductor structure (100), comprising:
(a) a semiconductor substrate (120) of one conductivity type, having a front surface (124) and a back surface (132) and comprising at least one via (110) through the semiconductor substrate (120), wherein the at least one via (110) is filled with a conductive material (118); and
(b) a semiconductor layer (200) disposed on at least a portion (136) of the front or back surface (124 or 132) of the semiconductor substrate (120), wherein the semiconductor layer (200) is compositionally graded through its depth with one or more selected dopants, and the conductive material (118) is configured to electrically couple the semiconductor layer (200) to at least one contact (270) disposed on or over the surface (132) of the substrate (120).

2. The semiconductor structure (100) of claim 1, wherein the semiconductor layer (200) comprises a crystalline layer (200).

3. The semiconductor structure (100) of claim 2, wherein the crystalline layer (200) comprises a plurality of same or different crystalline layers (620).

4. The semiconductor structure (100) of claim 2, wherein the crystalline layer (200) comprises a nano-crystalline material, a micro-crystalline material, a poly-crystalline material, an epitaxial layer, or a combination thereof.

5. The semiconductor structure (100) of any one of the preceding claims, wherein the semiconductor layer (200) comprises n-type or p-type dopants.

6. The semiconductor structure (100) of any one of the preceding claims, wherein an interface (210) between the semiconductor layer (200) and the semiconductor substrate (120) comprises a selected n-type or p-type dopant.

7. The semiconductor structure (100) of any one of the preceding claims, wherein the semiconductor substrate (120) comprises a mono-crystalline material or a multi-crystalline material.

8. The semiconductor structure (100) of any one of the preceding claims, wherein the semiconductor layer (200) comprises an amorphous layer (200).

9. The semiconductor structure (100) of claim 8, wherein the amorphous layer (200) comprises a-Si:H, a-SiC:H, a-SiGe:H, or a combination thereof.

10. The semiconductor structure (100) of claim 4, wherein the crystalline layer (200) comprises:
µc-Si:H, µc-SiC:H, µc-SiGe:H, or a combination thereof.
